# EUROPEAN PATENT APPLICATION

(11) **EP 1 640 482 A1**
(43) Date of publication of application: **29.03.2006**
(21) Application number: 04722384.7
(22) Date of filing: 22.03.2004
(51) Int. Cl.: C30B 29/04, C01B 31/06, C23C 14/06, C23C 14/28

(54) **PROCESS FOR PRODUCING EXTREMELY FLAT MICROCRYSTALLINE DIAMOND THIN FILM BY LASER ABLATION METHOD**

(30) Priority: 30.05.2003 JP 2003155406; 28.11.2003 JP 2003398298
(71) Applicant: Japan Science and Technology Agency, Kawaguchi-shi, Saitama 332-0012 (JP)
(72) Inventor: YOSHITAKE, Tsuyoshi, Dazaifu-shi, Fukuoka 818-0101 (JP); NAGAYAMA, Kunihito, Fukuoka-shi, Fukuoka 811-1346 (JP); HARA, Takeshi, Rm. 405, Heights Higashi-ohri, Onojo-shi, Fukuoka 816-0941 (JP)
(74) Representative: Röthinger, Rainer
(86) International application number: PCT/JP2004/003886
(87) International publication number: WO 2004/106595

(57) **Abstract**

Diamond thin films deposited by known PLD processes are composed of diamond crystal grains with a size of about 1 µm and have an irregular surface.

A process for producing an ultraflat nanocrystalline diamond thin film by laser ablation includes creating atomic hydrogen and a supersaturated state of carbon in a space between a target and a substrate in a hydrogen atmosphere inside a reaction chamber at a substrate temperature of 450°C to 650°C, a laser energy of 100 mJ or more, and a target-substrate distance of 15 to 25 mm to enable the growth of an ultraflat, single-phase nanocrystalline diamond thin film containing substantially no non-diamond component. The hydrogen atmosphere has a sufficient pressure to selectively completely etch off sp2 bond fractions (graphite fractions) deposited on the substrate with sp3 bond fractions remaining.

## Description

### Technical Field

The present invention relates to processes for producing an ultraflat nanocrystalline diamond thin film by laser ablation (pulsed laser ablation), which is one of the physical vapor deposition methods.

### Background Art

Methods for producing thin films are broadly divided into physical vapor deposition (PVD) and chemical vapor deposition (CVD). Most studies on the deposition of diamond thin films are based on CVD, which has allowed the deposition of single-phase diamond films. Films achieved by known CVD methods, however, have a surface roughness of not less than 70 nm. Recent technology has succeeded in depositing ultraflat films with a surface roughness of about 1 nm or less and has reached the stage of examination for application to devices, though the growth of extremely flat films involves extremely low deposition rates, namely 20 to 30 nm/hour. For PVD, growth by sputtering or ion beam deposition has been attempted, though no continuous advances have been achieved, and few studies are now progressing.

Among the PVD methods, laser ablation has recently been applied to various materials including oxides and compound semiconductors and has attracted attention for its advantage of providing high-quality films at low temperature. Laser ablation has unique features including: (1) growth by high-energy particle deposition at lower temperatures than other methods; (2) a tendency to generate a metastable phase or a nonequilibrium phase; (3) the production of high-purity films; (4) small deviations from the composition of a target; and (5) the simplicity of the apparatus used. Among them, the features (1) to (3) seem to be extremely effective for production of diamond thin films, though few attempts have been made.

Among laser ablation processes using graphite as a target, Patent Document 1 discloses a diamond growth process using photo-assisted CVD with a combination of a hydrogen atmosphere and light irradiation for dissociation of the atmospheric gas. Unfortunately, this process can only produce diamond grains and involves low deposition rates because of a large target-substrate distance.

Patent Document 2 (U.S. Pat. No. 5,368,681) discloses a process for producing a diamond film on a Si substrate by laser ablation with a polymer target at a substrate temperature of 450°C to 700°C and a target-substrate distance of 30 to 40 mm using oxygen or hydrogen as a reaction gas. The resultant film, however, is an irregular film composed of a large number of crystal grains, as shown in the SEM photographs in Figs. 4 and 5 of the document, and has a discontinuous mixed phase of residual amorphous carbon and diamond, as shown in the Raman spectrum in Fig. 6 of the document.

M. C. Polo et al. reported in 1995 that an amorphous carbon thin film containing nanocrystalline diamond can be formed by laser ablation at low substrate temperatures in the vicinity of 450°C. This film is an amorphous carbon film in which diamond crystal grains are precipitated. In addition, Patent Document 3 discloses a process for producing a thin film of a carbonaceous substance by laser ablation. In this process, crystals of a predetermined carbonaceous substance are selectively allowed to grow through a photochemical reaction according to the irradiation conditions of reaction light.

A patent application has been made for an invention that provides a process for depositing a diamond film or a diamond-like carbon (DLC) film by feeding a hydrogen gas at about 5 x 10⁻³ Torr into a laser irradiation atmosphere with a graphite target and a substrate being separated by a distance of 60 mm or more (Patent Document 4). However, any of the resultant films shown in the embodiments is a DLC film, and the document teaches that a larger target-substrate distance provides a film that is more similar to diamond. Afterwards, Yoshimoto et al. reported in 1999 that diamond crystals with diameters of several micrometers can be allowed to grow heteroepitaxially in an amorphous carbon film on a sapphire substrate by laser ablation in an oxygen atmosphere, and a patent application has been made for a related invention (Patent Document 5). Another patent application has been made for an invention that provides a process for allowing a DLC film to grow at high speed with a fèmtosecond laser (Patent Document 6). The present inventors have reported a study of processes for growth of diamond thin films by laser ablation (Non-Patent Document 1). Patent Document 1: Japanese Unexamined Patent Application Publication No. 6-234594
Patent Document 2: U.S. Pat. No. 5,368,681, the specification and the drawings
Patent Document 3: Japanese Unexamined Patent Application Publication No. 7-291773
Patent Document 4: Japanese Unexamined Patent Application Publication No. 11-100295
Patent Document 5: Japanese Unexamined Patent Application Publication No. 11-246299
Patent Document 6: WO00/22184
Non-Patent Document 1: Tsuyoshi Yoshitake et al., "Consideration of growth process of diamond thin films in ambient oxygen by pulsed laser ablation of graphite," Applied Surface Science, vol. 197-198, 352-356(2002)

### Disclosure of Invention

Diamond thin films deposited by known PLD processes are composed of diamond crystal grains with a size of about 1 µm and have an irregular surface. There has been no report that a continuous, single-phase nanocrystalline diamond film can be achieved which contains no non-diamond component and is ultraflat, that is, flat at the atomic level with a roughness of about 1 nm or less according to AFM measurement. Flatter diamond films are demanded for future application to devices. In addition, diamond thin films are conventionally produced by, for example, low-pressure CVD or GSMBE, though the growth rate is very low, namely several micrometers per hour for low-pressure CVD and several angstroms per hour for GSMBE. High-speed growth of nanocrystalline diamond thin films by PLD is significantly advantageous for industrial applications.

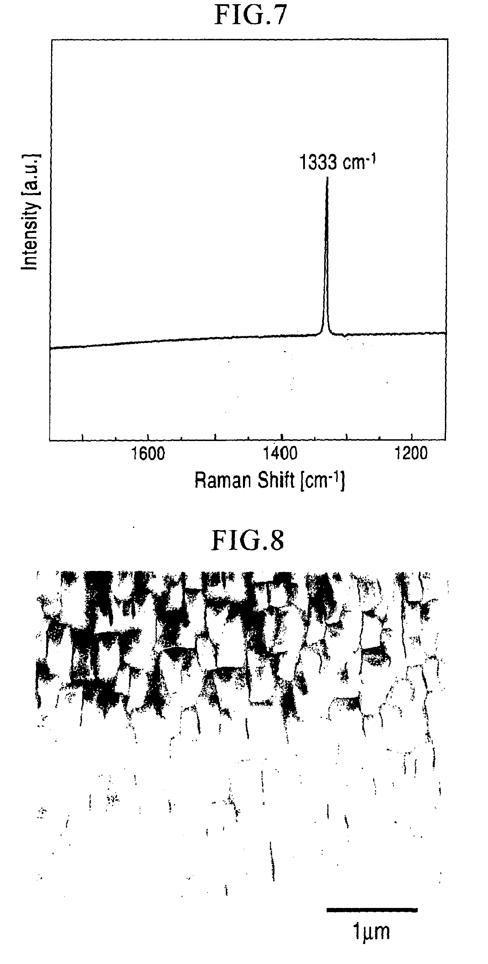

Fig. 8 shows an SEM image of a diamond film produced by laser ablation using oxygen as an atmospheric gas in a previous study by the present inventors. In this study, sp3 bond fractions, which are attributed to diamond, and sp2 bond fractions, which are attributed to graphite and amorphous carbon, occurred on a substrate because graphite (99.99%) was used as the target material in the growth process of the diamond thin film by laser ablation.

A single-phase diamond film can be allowed to grow by removing sp2 bond fractions with sp3 bond fractions remaining on a substrate. In the studies so far, the present inventors have succeeded in producing a single-phase diamond film using oxygen as an atmospheric gas to remove sp2 bond fractions (graphite fractions). Oxygen has the effect of selectively etching off sp2 bond fractions (graphite fractions); only sp3 bond fractions (diamond fractions) can be allowed to grow on a substrate by optimizing the production conditions. The resultant film, however, includes diamond crystal grains with a size of about 1 µm and has an irregular surface, and thus has difficulty in being applied to electronic devices and coatings in future.

The present inventors have developed a process for producing a diamond film by laser ablation. In this process, hydrogen is used instead of oxygen, the pressure of the hydrogen atmosphere is increased according to the laser energy used, and a supersaturated state of carbon is created. This process has succeeded in achieving ultrahigh-speed deposition of a continuous, substantially single-phase nanocrystalline diamond thin film that is ultraflat, that is, flat at the atomic level with a roughness of about 1 nm or less according to AFM measurement.

That is, the present invention provides (1) a process for producing an ultraflat nanocrystalline diamond thin film by laser ablation. This process includes creating atomic hydrogen and a supersaturated state of carbon in a space between a target and a substrate in a hydrogen atmosphere inside a reaction chamber at a substrate temperature of 450°C to 650°C, a laser energy of 100 mJ or more, and a target-substrate distance of 15 to 25 mm to enable the growth of an ultraflat, single-phase nanocrystalline diamond thin film containing substantially no non-diamond component. The hydrogen atmosphere has a sufficient pressure to selectively completely etch off sp2 bond fractions (graphite fractions) deposited on the substrate with sp3 bond fractions remaining.

In the process for producing an ultraflat nanocrystalline diamond thin film by laser ablation according to Item (1), (2) the hydrogen atmosphere has a pressure of 2 Torr or more.

In the process for producing an ultraflat nanocrystalline diamond thin film by laser ablation according to Item (1) or (2), (3) the growth rate of the diamond thin film is 4 µm/hour or more.

In the process according to the present invention, a hydrogen atmosphere is created inside the reaction chamber with a sufficient hydrogen atmosphere pressure to selectively completely etch off sp2 bond fractions (graphite fractions) deposited on the substrate, and the target-substrate distance is adjusted to 15 to 25 mm. Because particles are emitted substantially in a direction perpendicular to the surface of the target in the ablation, the target-substrate distance may be defined as the distance between a laser-irradiated spot on the surface of the target and the intersection point of a line extending perpendicularly from the laser-irradiated spot and the substrate.

An extremely small target-substrate distance, namely 15 to 25 mm, provides a higher degree of supersaturation of supersaturated carbon, which is essential for the growth of diamond in a high-temperature, high-pressure phase. Such a small distance also causes high-energy carbon particles emitted from the target to collide with atmospheric hydrogen, which then dissociates into atomic hydrogen. As a result, excited carbon atoms and molecules and atomic hydrogen occur in an ablation plume surrounding the substrate. This allows a simultaneous supply of supersaturated carbon and hydrogen for the growth of diamond on the substrate.

Atomic hydrogen has been found to have two effects. One of them is the effect of selectively etching off sp2 bond fractions (graphite fractions), though the effect is weaker than that of oxygen. The pressure of the hydrogen is preferably about 2 to 10 Torr for an extremely small target-substrate distance, namely 15 to 25 mm, because of the weaker effect (for oxygen, a pressure of 50 to 70 mTorr is preferred).

The other is the effect of linking diamond crystal grains to facilitate the growth of a continuous film. When diamond starts growing on a substrate in a supersaturated state of carbon, atomic hydrogen intrudes between diamond crystal grains so as to link them. The atomic hydrogen moves to the surface of the film at the stage where the diamond crystals grow while combining with each other, so that substantially no atomic hydrogen remains in the film. That is, the atomic hydrogen acts as a surfactant. For CVD, hydrogen originating mainly from CH₄ remains in resultant films. Such residual hydrogen decreases the optical transmittance and hardness of the films, degrading the quality of the films. Thus, the advantage of leaving less atomic hydrogen is preferred for the growth of high-quality films. If the supersaturated state is not achieved because of a large target-substrate distance, the atomic hydrogen combines with carbon atoms to form hydrogenated amorphous carbon.

While films that are composed of crystal grains and are discontinuous in a plane are produced according to reports that have so far been made, the process according to the present invention enables the growth of a continuous, single-phase nanocrystalline diamond film by means of the above two effects. The resultant film is ultraflat with a surface roughness of about 1 nm or less. In addition, the film contains substantially no non-diamond component. In Raman spectrometry, the film exhibits only a sharp peak at 1,333 cm⁻¹, which is attributed to diamond. Furthermore, the film can be allowed to grow at ultrahigh speed, namely about 4 µm/hour or more. Table 1 shows the properties of nanocrystalline diamond in comparison with those of diamond-like carbon, polycrystalline diamond, and single-crystal diamond.

**[Table 1]**

| | Diamond-like carbon | Nanocrystalline diamond | Polycrystalline diamond | Single-crystal diamond |
|---|---|---|---|---|
| | Amorphous | Nanocrystal | Polycrystal | Single crystal |
| Growth on foreign substrate | Easy | Possible | Difficult | Extremely difficult |
| Stability against temperature | Deteriorate with temperature because of nonequilibrium phase | Stable | Stable | Stable |
| Bandgap | Vary below 5.6 eV depending on sp2-to-sp3 ratio | 5.6 eV | 5.6 eV | 5.6 eV |
| Insulation | Good | Good | Good | Excellent |
| Film flatness | Flat | Flat | Irregular | Flat |
| Smoothness | Excellent | Excellent | Excellent | Fair |
| Thermal conductivity | Poor | Excellent | Excellent | Excellent |
| Transmittance | Good | Excellent | Excellent | Excellent |
| | | | | |
| Potential as semiconductor operable at high temperature | Poor | Good | Good | Fair |
| Potential as coating material | Excellent | Excellent | Fair | Poor |
| Potential as heat sink material | Poor | Excellent | Fair | Poor |

In terms of crystal grain size, nanocrystalline diamond, which has a crystal grain size on the order of nanometers, lies between amorphous diamond-like carbon (DLC) and polycrystalline diamond (with a crystal grain size on the order of micrometers). Nanocrystalline diamond features the advantages of both DLC and polycrystalline diamond. While DLC, which is of a nonequilibrium phase, disadvantageously deteriorates with temperature at about 100°C or more, nanocrystalline diamond is extremely stable.

On the other hand, single-crystal diamond and polycrystalline diamond are difficult to produce. Even if they can be produced, they often contain gaps between crystal grains and tend to form irregular, discontinuous films. Nanocrystalline diamond can overcome such problems without substantially impairing the other advantages of diamond.

Ultraflat, single-phase diamond films are demanded for future application to devices. Ultraflat nanocrystalline diamond films can be allowed to grow at ultrahigh speed using hydrogen as an atmospheric gas at high hydrogen atmosphere pressure by reducing a target-substrate distance.

### Brief Description of the Drawings

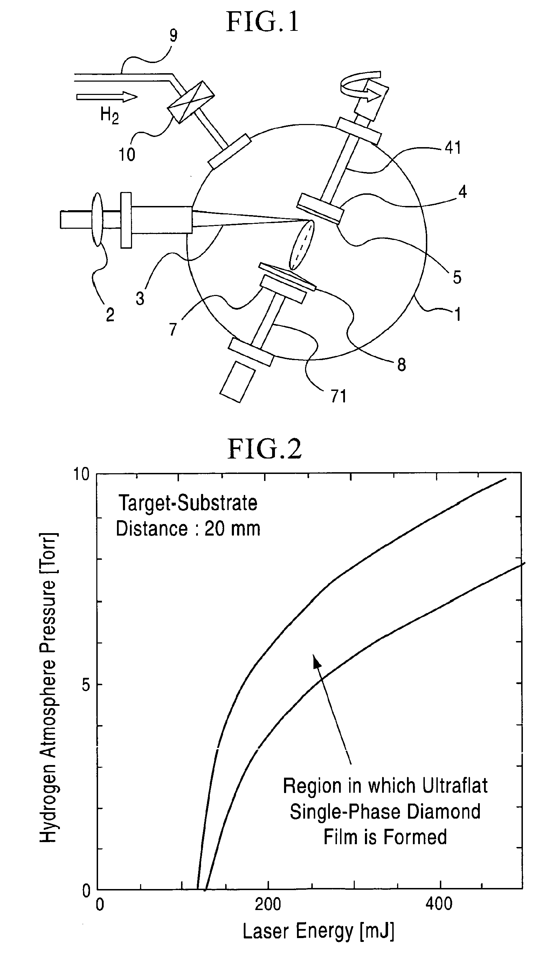

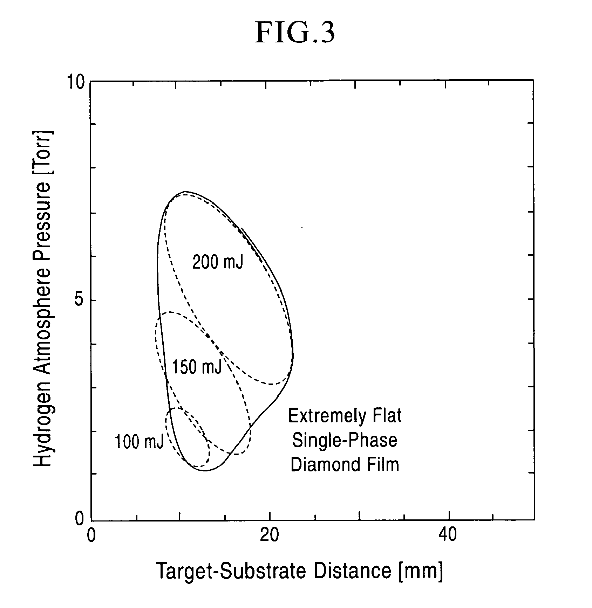

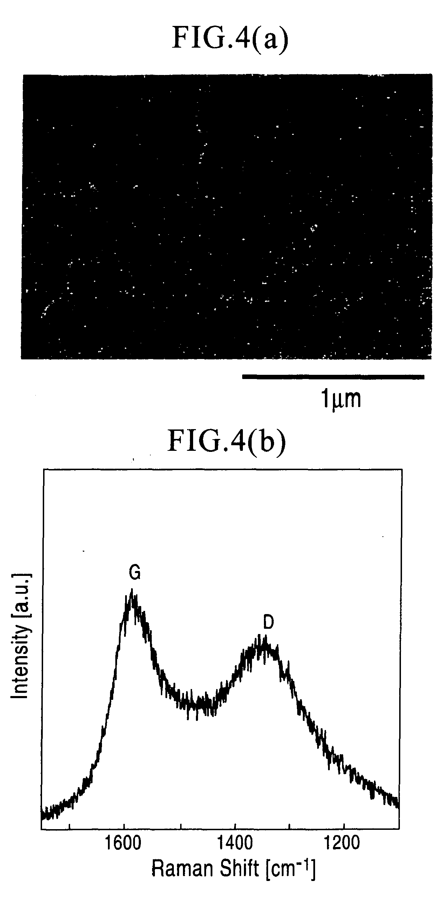

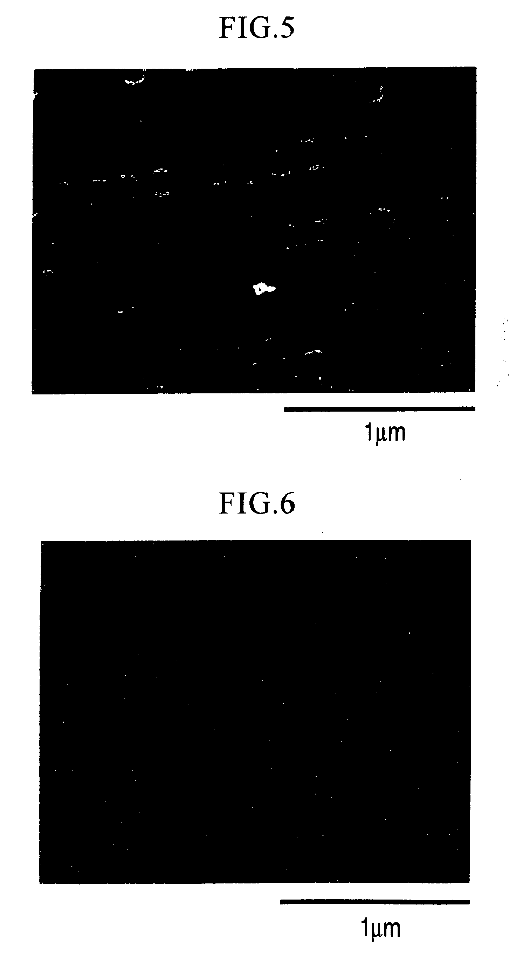

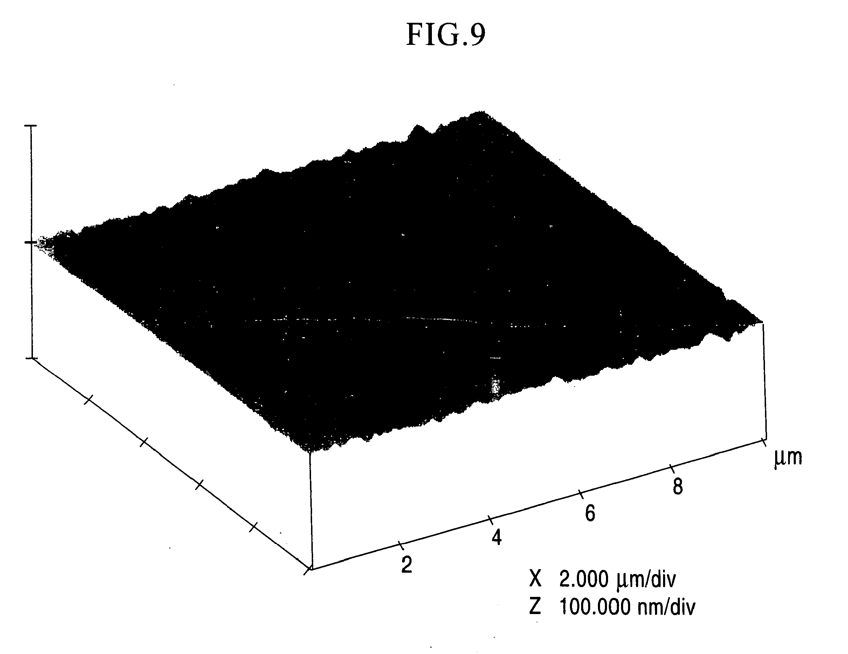

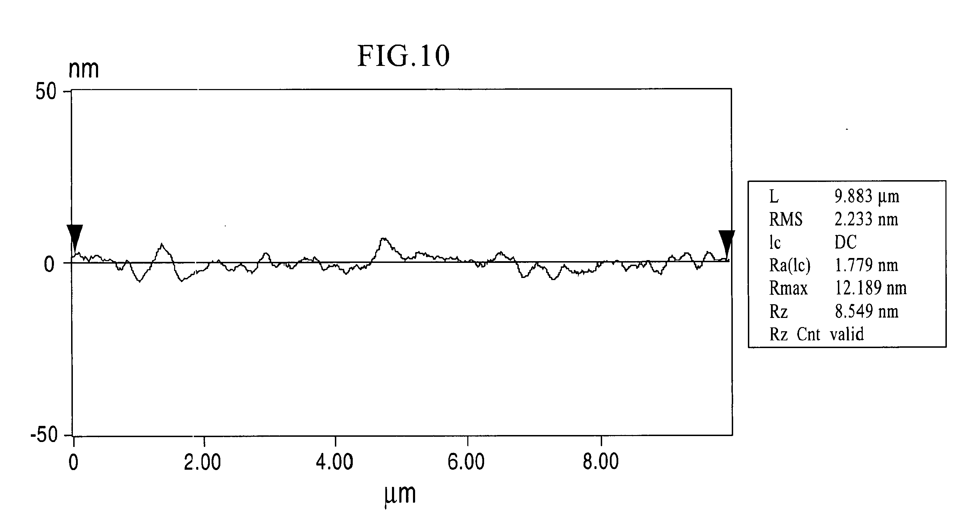

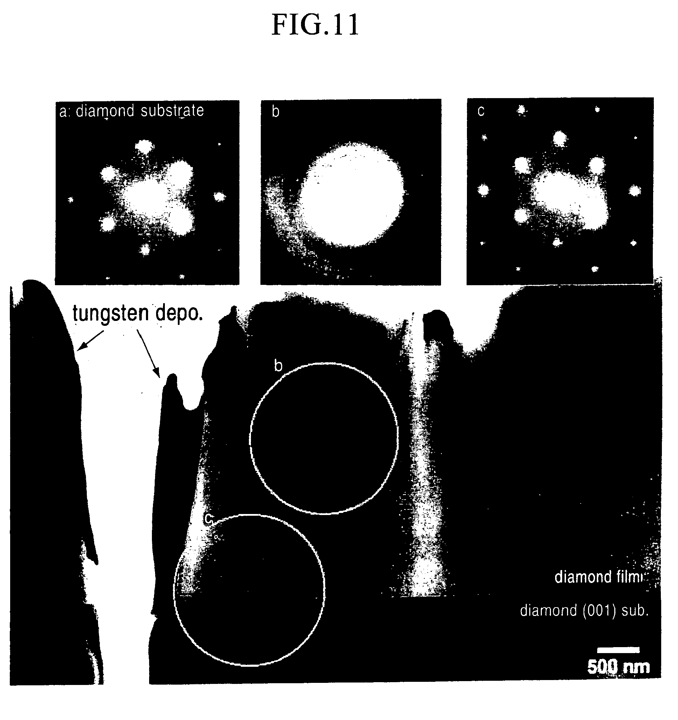

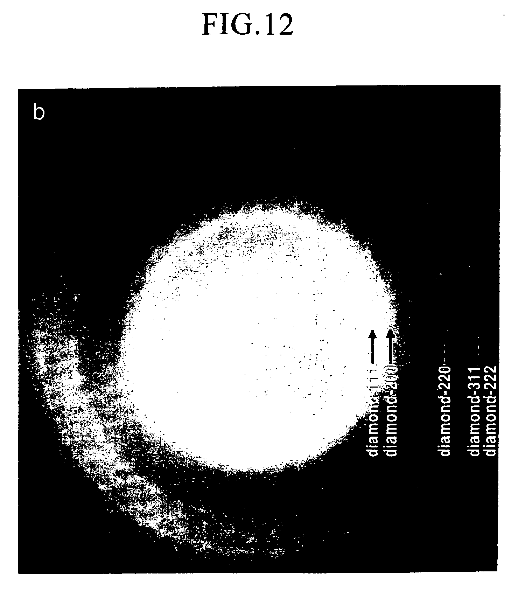

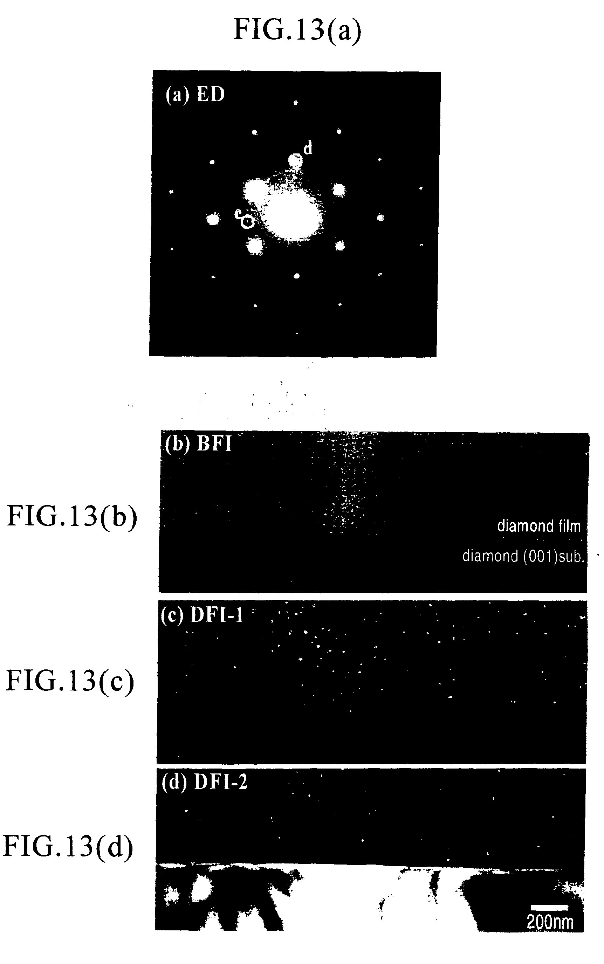

Fig. 1 is a schematic diagram of an apparatus for forming a diamond thin film by laser ablation in a process according to the present invention. Fig. 2 is a graph showing a region in which an ultraflat single-phase diamond film is formed according to the relationship between laser energy and hydrogen atmosphere pressure in the process according to the present invention. Fig. 3 is a graph showing a region in which an ultraflat single-phase diamond film is formed according to the relationship between hydrogen atmosphere pressure and target-substrate distance in the process according to the present invention. Fig. 4 shows a photograph (a) showing an SEM image of an amorphous carbon thin film deposited at a hydrogen pressure of 2 Torr and a substrate temperature of 550°C in Comparative Example 2 and a graph (b) showing the Raman spectrum of the thin film. Fig. 5 is a photograph showing an SEM image of a film deposited at a hydrogen pressure of 3 Torr and a substrate temperature of 550°C in Comparative Example 3. Fig. 6 is a photograph showing an SEM image of a film deposited at a hydrogen pressure of 4 Torr and a substrate temperature of 550°C in Example 1. Fig. 7 is a graph showing the Raman spectrum of the film deposited at a hydrogen pressure of 4 Torr and a substrate temperature of 550°C in Example 1. Fig. 8 is a photograph showing an SEM image of a diamond thin film produced using oxygen as an atmospheric gas in an example of the related art. Fig. 9 is a photograph showing an AFM image of the film deposited at a hydrogen pressure of 4 Torr and a substrate temperature of 550°C in Example 1. Fig. 10 is a graph showing a surface roughness profile obtained by AFM measurement of the film deposited at a hydrogen pressure of 4 Torr and a substrate temperature of 550°C in Example 1. Fig. 11 shows photographs of a cross-sectional bright-field image of the film deposited in Example 1 (including a substrate) and electron diffraction patterns at different sites. Fig. 12 is a photograph of a diffraction ring at each of the sites in Fig. 11. Fig. 13 shows photographs of a diffraction pattern (a) of the film deposited in Example 1 (including the substrate), a bright-field image (b) of the film, and dark-field images (c) and (d) of the film with diffracted light in the diffraction pattern (a).

### Best Mode for Carrying Out the Invention

In a process for growing a diamond film according to the present invention, carbon is emitted from a target of, for example, graphite, fullerene, or a hydrocarbon such as polyethylene by laser ablation substantially in a hydrogen gas atmosphere to deposit a diamond film on a substrate formed of, for example, diamond, SiC, Si, sapphire, platinum, or palladium.

Fig. 1 is a schematic view from above of an example of an apparatus for forming a diamond thin film in the process according to the present invention. A lens 2 focuses a laser beam 3 onto a target 5 held by a target holder 4 in a reaction chamber 1 to deposit carbon particles emitted from the target 5 on a substrate 8 held by a substrate holder 7. The target holder 4 and the substrate holder 7 are rotated about rotating shafts 41 and 71, respectively. The reaction chamber 1 is supplied with hydrogen gas as an atmospheric gas through a pipe 9 and an on-off valve 10.

The laser energy used in the process according to the present invention is preferably 100 mJ or more. For a laser energy below 100 mJ, an insufficient amount of particles are emitted from the target, and thus a supersaturated state for producing diamond on the substrate is difficult to create, and the deposition rate is low. As the laser energy is increased, a larger amount of high-energy particles can be supplied to the substrate to create a supersaturated state more easily so that a diamond film can grow at a higher speed. For low laser energy, amorphous carbon grows because only a small amount of carbon particles are supplied to the substrate.

The optimum hydrogen atmosphere pressure varies according to the target-substrate distance and the laser energy. An ultraflat, flawless diamond thin film can be achieved by finding the optimum value of the hydrogen atmosphere pressure. The hydrogen atmosphere pressure that is optimum for formation of an ultraflat diamond film increases with increasing laser energy. If, for example, the laser energy is 125 mJ with a target-substrate distance of 20 mm, an ultraflat diamond film grows at a hydrogen atmosphere pressure of 2 Torr. For a laser energy of 200 mJ, a hydrogen atmosphere pressure of at least 4 Torr is required for the deposition of an ultraflat diamond film. Fig. 2 schematically shows the relationship between the laser energy and the hydrogen atmosphere pressure. Fig. 2 indicates a region defined by the laser energy and the hydrogen atmosphere pressure which is suitable for forming an ultraflat, single-phase diamond film for a target-substrate distance of 20 mm.

On the other hand, the target-substrate distance is reduced with increasing hydrogen atmosphere pressure in order to form an ultraflat, single-phase diamond film. This relationship is schematically shown in Fig. 3. If the laser energy is increased to such a level that the hydrogen atmosphere pressure must be increased to more than 10 Torr, the atmospheric hydrogen excessively scatters the particles emitted from the target. As a result, the kinetic energy of the particles decreases before they reach the substrate, and thus a supersaturated state cannot be created.

Whether sp2 bond fractions (graphite fractions) can be selectively etched off seems to depend on the ratio of the amount of atmospheric hydrogen to that of carbon deposited on the substrate. As the amount of film deposited increases with increasing laser energy, the amount of sp2 bond fractions (graphite fractions) formed increases. Accordingly, a larger amount of hydrogen is required to selectively etch off the sp2 bond fractions.

The hydrogen molecules in the atmosphere are automatically supplied to the substrate in atomic form because they dissociate in plasma. For low hydrogen atmosphere pressure, the sp2 bond fractions (graphite fractions) cannot be sufficiently etched off and therefore remain. For high hydrogen atmosphere pressure, the hydrogen molecules scatter the carbon particles emitted from the target, thus decreasing the amount and energy of carbon particles reaching the substrate and failing to create a supersaturated state.

If, however, the target-substrate distance is significantly reduced to 15 to 25 mm, a supersaturated state of carbon, which is essential for the growth of diamond in a high-temperature, high-pressure phase, can be created. If the target-substrate distance exceeds 25 mm, the conditions for supersaturation cannot be satisfied because of an insufficient carbon supply. If the target-substrate distance falls below 15 mm, the target cannot be irradiated with a laser beam for geometrical reasons.

The temperature of the substrate is preferably about 450°C to 650°C. If the substrate temperature falls below this range, amorphous carbon grows because the mobility of the particles deposited on the substrate decreases. If the substrate temperature exceeds the above range, the growing diamond relaxes, and thus graphite grows as a stable phase.

### Examples

The present invention is more specifically described with examples and comparative examples below.

Films were formed on diamond(100) substrates separated from a target by a distance of 20 mm by focusing a laser beam emitted from an ArF excimer laser (λ = 193 nm) onto the surface of the target at an incident angle of 45° and an irradiation area of about 2 mm² The diamond(100) substrates were subjected to ultrasonic cleaning with acetone in advance. The substrate temperature was 550°C. The repetition frequency was 50 Hz. The fluence rate was 10 J/cm². The laser energy was 200 mJ.

The target used was graphite (99.99%). The chamber was evacuated to not more than 10⁻⁶ Torr with a turbo molecular pump, and hydrogen was allowed to flow into the chamber to prepare the films. Comparative Examples 1 to 3 and Example 1 are different only in hydrogen pressure. The surfaces of the resultant films were examined using a scanning electron microscope (SEM), and the film structures were examined using a Raman spectrometer.

### Comparative Example 1

The hydrogen pressure was 1 Torr. According to Raman spectrometry, G and D peaks were observed, which indicate the growth of typical amorphous carbon. No diamond was found on the film surface in the observation by SEM.

### Comparative Example 2

The hydrogen pressure was 2 Torr. For the hydrogen pressure, a large number of regularly arranged square particles with a diameter of about 0.5 µm were observed, as shown in Fig. 4(a). According to Raman spectrometry, G and D peaks, which indicate amorphous carbon, were observed, as shown in Fig. 4(b).

### Comparative Example 3

The hydrogen pressure was 3 Torr. For the hydrogen pressure, regions including square particles regularly arranged in strips with a diameter of about 0.2 µm were observed, as shown in Fig. 5. G and D peaks, which depend on amorphous carbon, were observed in the Raman spectrum for each of the regions.

### Example 1

The hydrogen pressure was 4 Torr. For the hydrogen pressure, a film that was ultraflat over the surface was observed, as shown in Fig. 6. According to Raman spectrometry, only a shape peak at 1,333 cm⁻¹, which is attributed to diamond, was observed, as shown in Fig. 7. These results indicate the growth of single-phase diamond containing substantially no non-diamond component.

A comparison of the SEM image in Fig. 6 with the SEM image in Fig. 8, which shows a diamond film produced using oxygen as an atmospheric gas, reveals that the film produced using hydrogen as an atmospheric gas was ultraflat. Fig. 9 shows an AFM image of the diamond film produced in Example 1. Fig. 10 shows a surface irregularity profile obtained by AFM measurement. A stripe pattern derived from the diamond substrate was observed. The average surface roughness was measured to be 2.2 nm; the film can be determined to be ultraflat at the atomic level with a roughness of about 1 nm or less without the irregularities of the substrate.

The thicknesses of the deposited films were measured using a surface roughness tester. When the atmospheric gas used was oxygen, the deposition rate was about 1 µm for one to one and a half hours. When the atmospheric gas used was hydrogen, the deposition rate was about 5 to 5.5 µm for the same period of time. At present, the time required for the growth of diamond by CVD is said to be 6 to 40 hours. The above results show that the process according to the present invention realizes a significantly high deposition rate.

The nanocrystalline diamond thin film was observed using a transmission electron microscope. Fig. 11 shows a cross-sectional bright-field image of the film (including the substrate) and electron diffraction patterns at different sites. According to the observation, the substrate showed a diffraction image typical of diamond, and the film showed ring patterns corresponding to various lattice planes of diamond, meaning that the film was unoriented. Fig. 12 shows that each diffraction ring was due to diffracted light from diamond. Fig. 13 shows a bright-field image (b) and dark-field images (c) and (d) with diffracted light at spots c and d, respectively, in a diffraction pattern (a). These images show that the resultant film included nanocrystalline diamond grains with a size of 20 nm or less.

### Example 2

A continuous, ultraflat, single-phase nanocrystalline diamond thin film grew under the same conditions as in Example 1 except that the laser energy was 150 mJ, the target-substrate distance was 15 mm, and the hydrogen pressure was 2 Torr.

### Comparative Example 4

Amorphous carbon grew under the same conditions as in Example 1 except that the target-substrate distance was 30 mm.

### Industrial Applicability

A nanocrystalline diamond film produced by a process according to the present invention has excellent properties, as shown in Table 1. In particular, this diamond film has higher potential as a semiconductor operable at high temperature, a coating material, and a material for heat sinks than other types of diamond films.

## Claims

1. A process for producing an ultraflat nanocrystalline diamond thin film by laser ablation, comprising creating atomic hydrogen and a supersaturated state of carbon in a space between a target and a substrate in a hydrogen atmosphere inside a reaction chamber at a substrate temperature of 450°C to 650°C, a laser energy of 100 mJ or more, and a target-substrate distance of 15 to 25 mm to enable the growth of an ultraflat, single-phase nanocrystalline diamond thin film containing substantially no non-diamond component, the hydrogen atmosphere having a sufficient pressure to selectively completely etch off sp2 bond fractions (graphite fractions) deposited on the substrate with sp3 bond fractions remaining.

2. The process for producing an ultraflat nanocrystalline diamond thin film by laser ablation according to Claim 1, wherein the hydrogen atmosphere has a pressure of 2 Torr or more.

3. The process for producing an ultraflat nanocrystalline diamond thin film by laser ablation according to Claim 1 or 2, wherein the growth rate of the diamond thin film is 4 µm/hour or more.
